# EUROPÄISCHE PATENTSCHRIFT

(11) **EP 3 437 112 B1**
(45) Veröffentlichungstag und Bekanntmachung des Hinweises auf die Patenterteilung: **13.05.2020**
(21) Anmeldenummer: 17707512.4
(22) Anmeldetag: 23.02.2017
(51) Int. Cl.: H01G 4/30, H01G 4/38, H01G 2/06, H01G 4/232

(54) **KONDENSATORANORDNUNG**
CAPACITOR ASSEMBLY
AGENCEMENT DE CONDENSATEUR

(30) Priorität: 31.03.2016 DE 102016105910
(43) Veröffentlichungstag der Anmeldung: 06.02.2019
(73) Patentinhaber: TDK Electronics AG, 81671 München (DE)
(72) Erfinder: KONRAD, Jürgen, 8042 Graz (AT); KOINI, Markus, 8054 Seiersberg (AT); RINNER, Franz, 8530 Deutschlandsberg (AT)
(74) Vertreter: Epping - Hermann - Fischer
(86) Internationale Anmeldenummer: PCT/EP2017/054214
(87) Internationale Veröffentlichungsnummer: WO 2017/167507

(56) Entgegenhaltungen:
- JP-A- 2010 161 172
- US-A- 4 661 884
- US-A1- 2010 046 135
- US-A1- 2015 206 661

## Beschreibung

Die vorliegende Erfindung betrifft eine Kondensatoranordnung. Unter einer Kondensatoranordnung wird im Folgenden eine Anordnung verstanden, die einen Vielschichtkondensator sowie Mittel aufweist, die es ermöglichen, den Vielschichtkondensator auf einer Leiterplatte zu montieren, insbesondere die eine Oberflächenmontage des Vielschichtkondensators auf der Oberfläche der Leiterplatte ermöglichen.

Keramische Vielschichtkondensatoren ermöglichen es, eine Vielzahl verschiedener Anforderungen zu erfüllen, wodurch sie beispielsweise für den Einsatz als Zwischenkreiskondensator oder Snubberkondensator in elektrischen Schaltungen geeignet sind. In einer solchen Schaltung können sie als spannungsstabilisierendes Bauelement dienen. Dabei können die Vielschichtkondensatoren als Zwischenspeicher für überschüssige beziehungsweise fehlende Ladung dienen, wobei sie bei einem bestimmten Gleichspannungsniveau eine geforderte Ladungsmenge möglichst rasch aufnehmen beziehungsweise abgeben müssen. Die Ladungsaufnahmefähigkeit der Kondensatoren wird bestimmt von deren Kapazität. Für sich schnell wiederholende Ladevorgänge ist eine hohe Stromtragfähigkeit der Kondensatoren, insbesondere bei hohen Frequenzen, gefordert. Zusätzlich sollte zur Vermeidung von Überspannungsspitzen beim effizienten Schalten von Halbleitern eine möglichst niedrige Induktivität eines Kommutierungskreises des Kondensators erzielt werden.

An die Vielschichtkondensatoren werden ferner weitere elektrische Anforderungen gestellt. Insbesondere sollte ein Vielschichtkondensator geringe parasitäre Elemente, wie einen geringen äquivalenten Serienwiderstand ESR (Equivalent Serious Resistance) und eine geringe parasitäre Induktivität ESL (Equivalent Serious Inductance) aufweisen. Ferner sollten die Kondensatoren und ihre Anbindung an eine Leiterplatte eine hohe Wärmeleitfähigkeit aufweisen und hohe thermomechanische Anforderungen erfüllen. Beispielsweise sollten die Kondensatoren auch bei großen Temperaturänderungen, beispielsweise infolge eines thermischen Schocks, funktionsfähig bleiben.

Aus US 2010/046135 A1 ist ein Kondensator bekannt, der auf einem Substrat montiert ist, wobei einseitig positionierte Elektrodenanschlüsse über Außenkontaktierungen je nach Polarität der Elektroden direkt mit Leiterbahnen auf der Oberseite des Substrats oder über Durchkontaktierungen im Substrat mit Leiterbahnen auf der Unterseite des Substrats elektrisch verbunden sind.

JP 2010161172 A offenbart eine Kondensatorenanordnung mit mehreren Vielschichtkondensatoren auf einem Sockel.

Die vorliegende Erfindung beschäftigt sich insbesondere mit der Verbindungstechnik zwischen einem keramischen Vielschichtkondensator und einer Leiterplatte. Es sollte dabei eine Verbindung ermöglicht werden, die eine möglichst niedrige Induktivität aufweist und die eine gute elektrische und thermische Leitfähigkeit bietet. Um diese Anforderungen zu erfüllen, ist es vorteilhaft, dass eine Kondensatoranordnung möglichst großflächig an eine Leiterplatte montierbar ist. Ferner sollte jedoch der von der Kondensatoranordnung auf der Leiterplatte belegte Bauraum möglichst gering sein.

Aufgabe der vorliegenden Erfindung ist es dementsprechend, eine Kondensatoranordnung anzugeben, die eine besonders gute Verbindung mit einer Leiterplatte ermöglicht.

Diese Aufgabe wird durch eine Kondensatoranordnung gemäß dem vorliegenden Anspruch 1 gelöst.

Es wird eine Kondensatoranordnung vorgeschlagen, die zumindest einen keramischen Vielschichtkondensator, der keramische Schichten und dazwischen angeordnete erste und zweite Elektroden aufweist, und einen Sockel aufweist, der ein Substrat und Leiterbahnen aufweist, wobei die Leiterbahnen von einer zum Kondensator hinweisenden Oberseite des Substrats zu einer vom Kondensator wegweisenden Unterseite des Substrats führen, wobei der Vielschichtkondensator mechanisch auf dem Sockel befestigt ist und wobei die ersten Elektroden und die zweiten Elektroden mit den Leiterbahnen elektrisch kontaktiert sind.

Der Vielschichtkondensator weist Außenkontaktierungen auf. Der Vielschichtkondensator ist für einen einseitigen Anschluss ausgelegt. Dementsprechend sind sämtliche Außenkontaktierungen auf einer zum Sockel weisend Außenfläche des Vielschichtkondensators angeordnet. Die ersten Innenelektroden können dabei mit einer ersten Außenkontaktierung elektrisch verbunden sein und die zweiten Innenelektroden können mit einer zweiten Außenkontaktierung verbunden sein. Die erste und die zweiten Außenkontaktierung können ausschließlich auf der zum Sockel weisenden Außenfläche des Vielschichtkondensators angeordnet sein.

Die hier vorgeschlagene Anordnung des Vielschichtkondensators auf dem Sockel ermöglicht es, eine hohe elektrische und thermische Leitfähigkeit zwischen dem Vielschichtkondensator und dem Sockel zu gewährleisten und gleichzeitig eine Verbindung mit einer geringen Induktivität zu schaffen. Diese Eigenschaften der Verbindung können insbesondere dadurch ermöglicht werden, dass die mechanische Verbindung des Vielschichtkondensators mit dem Sockel auch zur elektrischen Kontaktierung genutzt werden kann. Dabei kann der Vielschichtkondensator insbesondere großflächig auf dem Sockel befestigt sein.

Ferner kann der Sockel auf einer Leiterplatte mittels Oberflächenmontage befestigt werden. Die vorgeschlagene Kondensatoranordnung ermöglicht dabei eine Verbindung des keramischen Vielschichtkondensators mit der Leiterplatte über den Sockel, wobei die Verbindung eine gute elektrische und thermische Leitfähigkeit bietet, eine geringe Induktivität aufweist und nur einen geringer Bauraumbedarf erforderlich ist. Bei der Oberflächenmontage kann der Sockel mit einer großen Fläche auf der Leiterplatte aufliegen, sodass auch zwischen dem Sockel und der Leiterplatte eine gute thermische Leitfähigkeit vorliegt. Dementsprechend kann in dem Kondensator bei Betrieb entstehende Hitze in ausreichendem Maß über den Sockel auf die Leiterplatte abgeleitet werden.

Die Verbindungen zwischen der Leiterplatte und dem Sockel sowie zwischen dem Sockel und dem Vielschichtkondensator können ferner derart ausgestaltet sein, dass die Verbindungen sowohl mechanisch stabil sind als auch eine zuverlässige elektrische Kontaktierung ermöglichen. Die Verbindungen führen ferner zu geringen Verlusten, da sie so ausgestaltet sein können, dass sie eine niedrige Induktivität aufweisen.

Die Kondensatoranordnung kann derart ausgestaltet sein, dass bei einer Oberflächenmontage der Kondensatoranordnung der Sockel zwischen der Leiterplatte und dem Vielschichtkondensator angeordnet ist. Bei dem Sockel kann es sich insbesondere um ein DCB-Bauteil handeln (DCB = Direct Copper Bonding), welches ein keramisches Substrat mit Kupferleiterbahnen aufweist.

Die Kombination eines keramischen Vielschichtkondensators mit einem DCB-Sockel erlaubt ein relativ einfaches Herstellungsverfahren, bei dem der keramische Vielschichtkondensator auf dem Sockel einfach aufgesetzt werden kann. Eine Verbindung zwischen dem Vielschichtkondensator und dem Sockel kann beispielsweise durch Silbersintern gefertigt werden. Die großflächige Anbindung stellt keine hohen Anforderungen an geometrische Toleranzen bei der Fertigung und ermöglicht somit eine einfache Prozessfolge.

Bei den ersten und zweiten Elektroden, die zwischen den keramischen Schichten angeordnet sind, handelt es sich um Innenelektroden des Vielschichtkondensators. Der Vielschichtkondensator kann ferner Außenelektroden, die auch als Außenkontaktierung bezeichnet werden, aufweisen, die mit den Elektroden elektrisch kontaktiert sind. Der Vielschichtkondensator kann ferner dritte Elektroden aufweisen, die nicht mit den Außenelektroden kontaktiert sind und auch als Floating Elektroden bezeichnet werden.

Das Substrat kann insbesondere ein keramisches oder dielektrisches Material aufweisen. Die Leiterbahnen bestehen aus einem leitfähigen Material. Die Leiterbahnen können auf dem Substrat aufgedruckt sein. Der Vielschichtkondensator kann mechanisch derart auf dem Sockel befestigt sein, dass er nicht zerstörungsfrei von dem Sockel getrennt werden kann.

Die ersten und die zweiten Elektroden des Vielschichtkondensators können jeweils an der zum Sockel weisenden Außenfläche des Vielschichtkondensators anliegen.

Die Elektroden und die keramischen Schichten können übereinander in einer Stapelrichtung S angeordnet sein, wobei die Stapelrichtung S senkrecht zu der Flächennormale der zum Vielschichtkondensator weisenden Oberfläche des Sockels sein kann.

Der Vielschichtkondensator kann eine erste Außenkontaktierung und eine zweite Außenkontaktierung aufweisen, die auf ein und derselben Außenfläche des Vielschichtkondensators angeordnet sind. Die übrigen Außenflächen des Vielschichtkondensators können frei von Außenkontaktierungen sein. Die ersten Elektroden können über die erste Außenkontaktierung mit einer der Leiterbahnen verbunden sein und die zweiten Elektroden können über die zweite Außenkontaktierung mit einer der Leiterbahnen verbunden sein.

Dementsprechend kann der Vielschichtkondensator für einen einseitigen Anschluss ausgelegt sein, bei dem sämtliche Außenkontaktierungen auf einer einzigen Außenfläche vorgesehen sind. Diese Außenfläche wird mechanisch auf dem Sockel befestigt und ist elektrisch mit dem Sockel kontaktiert. Die Ausgestaltung des Vielschichtkondensators für einen einseitigen Anschluss ermöglicht ein sehr einfaches Herstellungsverfahren der Kondensatoranordnung, bei dem der Vielschichtkondensator auf den Sockel aufgesetzt wird.

Der Vielschichtkondensator kann mit zumindest der Hälfte der ersten Außenfläche unmittelbar auf dem Sockel aufliegen. Eine so große Auflagefläche des Vielschichtkondensators auf dem Sockel kann eine hohe thermische und elektrische Leitfähigkeit der Verbindung des Vielschichtkondensators mit dem Sockel gewährleisten und für eine mechanisch stabile Befestigung sorgen. Vorzugsweise liegt der Vielschichtkondensator mit zumindest der 75 % der ersten Außenfläche unmittelbar auf dem Sockel auf.
Der keramische Vielschichtkondensator ist mit dem Sockel durch eine Silber aufweisende Schicht verbunden. Die Schicht kann zu 95 Gew.-% oder sogar zu 99 Gew.-% aus reinem Silber bestehen. Insbesondere kann der keramische Vielschichtkondensator mit dem Sockel durch eine Schicht verbunden sein, die durch das Auftragen einer Paste und anschließendes Sintern gebildet wird. Eine derartige Schicht wird auch als Sintersilberschicht bezeichnet. Sintersilbern ermöglicht es, eine Schicht zu fertigen, die eine sehr stabile mechanische Befestigung des Vielschichtkondensators an dem Sockel ermöglicht und die gleichzeitig eine hohe elektrische und thermische Leitfähigkeit aufweist. Ferner ermöglicht es die Sintersilbertechnik, eine sehr dünne Schicht zu fertigen, die beispielsweise eine Dicke von 5 bis 50 µm aufweist.

Die Kondensatoranordnung weist ferner zumindest einen zweiten keramischen Vielschichtkondensator auf, der ebenfalls keramische Schichten und dazwischen angeordnete Elektroden aufweist und der auf dem Sockel angeordnet ist, wobei die Elektroden des zweiten Vielschichtkondensators mit den Leiterbahnen elektrisch kontaktiert sind. Ein einzelner Sockel kann somit zur mechanischen Befestigung und elektrischen Kontaktierung einer Vielzahl von Vielschichtkondensatoren genutzt werden.

Der Sockel weist zumindest einen Schlitz auf, der zwischen dem keramischen Vielschichtkondensator und dem zweiten keramischen Vielschichtkondensator verläuft. Der Schlitz kann eine mechanische Entlastung bewirken, die beispielsweise durch unterschiedliche thermische Ausdehnungskoeffizienten verursachte mechanische Spannungen abbaut.

Der keramische Vielschichtkondensator und der zweite keramische Vielschichtkondensator können zueinander parallel geschaltet sein. Durch die Parallelschaltung der Vielschichtkondensatoren ergibt sich eine Kondensatoranordnung, deren Gesamtkapazität der Summe der Kapazitäten der Vielschichtkondensatoren entspricht. Die Parallelschaltung ermöglicht somit eine Kondensatoranordnung mit einer sehr hohen Kapazität zu konstruieren. Eine hohe Kapazität ist beispielsweise für eine hohe Ladungsaufnahmefähigkeit entscheidend.

Die Kondensatoranordnung kann ein SMD-Bauteil (SMD = Surface Mounted Device) sein. Dementsprechend kann die Kondensatoranordnung zur Oberflächenmontage auf einer Leiterplatte geeignet sein. Dabei kann die Kondensatoranordnung beispielsweise mittels Löten oder Silbersintern auf der Leiterplatte befestigt werden. Insbesondere kann die Kondensatoranordnung für eine Vielzahl verschiedener Methoden zur Oberflächenmontage auf der Leiterplatte geeignet sein.

Die Kondensatoranordnung kann dazu ausgestaltet sein, derart auf einer Leiterplatte befestigt zu werden, dass der Sockel mit einer Fläche von zumindest 40mm² unmittelbar auf einer Leiterplatte aufliegt. Beispielsweise kann der Sockel auf der Leiterplatte mit einer Fläche von 51,7 mm² aufliegen.

Das Material und die Dicke des Substrats sowie das Material und die Dicke der Leiterbahnen kann so gewählt werden, dass der Sockel einen thermischen Ausdehnungskoeffizienten aufweist, der an den thermischen Ausdehnungskoeffizienten des Vielschichtkondensators angepasst ist. Insbesondere kann sich der thermische Ausdehnungskoeffizient des Sockels um weniger als 0,5 ppm/K, vorzugsweise um weniger 0,1 ppm/K, von dem thermischen Ausdehnungskoeffizienten des Vielschichtkondensators unterscheiden. Durch eine Anpassung der thermischen Ausdehnungskoeffizienten aneinander kann sichergestellt werden, dass auch bei Temperaturänderungen die Kondensatoranordnung keinen hohen mechanischen Spannungen ausgesetzt wird, die sich andernfalls durch unterschiedliche Ausdehnungen von Sockel und Vielschichtkondensator ergeben würden. Der thermische Ausdehnungskoeffizient des Sockels wird durch das Verhältnis der Materialmenge des Substrats zu der Materialmenge der Leiterbahnen bestimmt. Durch eine entsprechende Wahl dieses Verhältnisses kann der thermische Ausdehnungskoeffizient auf einen gewünschten Wert eingestellt werden.

Der Vielschichtkondensator kann beispielsweise einen thermischen Ausdehnungskoeffizienten von 10 ppm/K aufweisen. Der Vielschichtkondensator kann im Wesentlichen aus einem keramischen Material, das beispielsweise einen thermischen Ausdehnungskoeffizienten von 3 ppm/K, und Innenelektroden, die beispielsweise aus Kupfer bestehen und einen deutlich höheren thermischen Ausdehnungskoeffizienten aufweisen, bestehen. Auch der thermische Ausdehnungskoeffizient des Vielschichtkondensators kann in gewünschter Weise eingestellt werden, indem das Verhältnis der Materialmenge des keramischen Materials und der Materialmenge der Innenelektroden entsprechend gewählt wird.

Als Material für das Substrat des Sockels kann beispielsweise Siliziumnitrid gewählt werden, das einen thermischen Ausdehnungskoeffizienten von 2,5 ppm/K aufweist. Als Material für das Substrat kann alternativ Aluminiumoxid gewählt werden, das einen thermischen Ausdehnungskoeffizienten von 6,8 ppm/K aufweist. Durch die Einstellung der Dicke einer Kupferschicht, die die Leiterbahnen des Sockels bildet, und durch die Einstellung der Dicke des Substrats kann nunmehr der thermische Ausdehnungskoeffizient des Sockels an den Kondensator angepasst werden. So würde beispielsweise bei einem Substrat aus Aluminiumoxid eine vergleichsweise dünne Kupferschicht gewählt werden und bei einem Substrat aus Siliziumnitrid eine vergleichsweise dicke Kupferschicht.

Der Sockel und der Vielschichtkondensator können die gleiche Breite aufweisen. Dementsprechend kann die Breite der Kondensatoranordnung der Breite des Vielschichtkondensators entsprechen. Somit ist eine Erhöhung der Breite zur Befestigung des Vielschichtkondensators auf einer Leiterplatte nicht notwendig. Dadurch kann der Bauraumbedarf der Kondensatoranordnung auf die Ausdehnungen des Vielschichtkondensators begrenzt werden.

Eine gleiche Breite soll hier so verstanden werden, dass die Breiten des Sockels und des Vielschichtkondensators sich lediglich im Rahmen der üblichen Fertigungstoleranzen voneinander unterscheiden. Dementsprechend kann die Breite des Sockels von der Breite des Vielschichtkondensators um weniger als 0,1 mm abweichen.

Das Substrat kann Siliziumnitrid, Aluminiumoxid oder Aluminiumnitrid aufweisen. Siliziumnitrid zeichnet sich insbesondere durch eine hohe thermische Leitfähigkeit von 30 W/mK aus. Aluminiumoxid weist eine thermische Leitfähigkeit von 20 W/mK auf. Das Substrat kann eine Dicke zwischen 0,1 mm und 2,0 mm aufweisen.

Die Leiterbahnen können aus Kupfer bestehen. Die Leiterbahnen können eine Dicke zwischen 0,05 mm und 1,0 mm aufweisen. Die Dicke der Leiterbahnen sollte nicht kleiner als 0,05 mm gewählt werden, um eine gute elektrische Leitfähigkeit zu gewährleisten.

Im Folgenden wird die Erfindung anhand der Figuren näher erläutert.
Figur 1 zeigt einen Querschnitt durch eine Kondensatoranordnung.
Die Figuren 2 bis 4 zeigen eine Elektrodenkonfiguration eines Vielschichtkondensators gemäß einem ersten Ausführungsbeispiel.
Die Figuren 5 bis 7 zeigen eine Elektrodenkonfiguration eines Vielschichtkondensators gemäß einem zweiten Ausführungsbeispiel.
Figur 8 zeigt ein weiteres Ausführungsbeispiel für eine Kondensatoranordnung.
Figur 9 zeigt einen Sockel in einer perspektivischen Ansicht.
Figur 10 zeigt den in Figur 9 gezeigten Sockel in einer Draufsicht.
Figur 11 zeigt den Sockel in einer Ansicht von vorn.
Figur 12 zeigt eine tabellarische Übersicht über Simulationsergebnisse, die verschiedene Eigenschaften verschiedener erfindungsgemäßer Kondensatoranordnungen mit einer Vergleichskondensatoranordnung vergleicht.

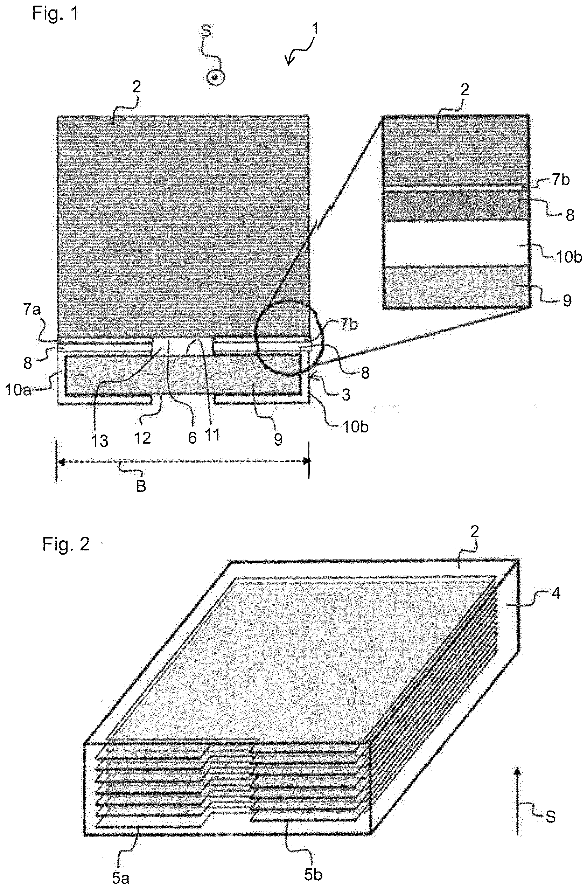

Figur 1 zeigt einen Querschnitt durch eine Kondensatoranordnung 1. Die Kondensatoranordnung 1 weist einen keramischen Vielschichtkondensator 2 und einen Sockel 3 auf. Ferner zeigt Figur 1 einen vergrößerten Ausschnitt aus dem Querschnitt, der es ermöglicht, Details der Kondensatoranordnung 1 zu erkennen.

Der keramische Vielschichtkondensator 2 weist übereinandergestapelte keramische Schichten 4 und dazwischen angeordnete Elektroden 5a, 5b, 5c auf. Verschiedene Ausführungsbeispiele für den Aufbau des keramischen Vielschichtkondensators 2 werden später anhand der Figuren 2 bis 7 erläutert. Auf einer ersten Außenfläche 6, die zu dem Sockel 3 hin gerichtet ist, weist der keramische Vielschichtkondensator 2 zwei Außenkontaktierungen 7a, 7b auf. Die Elektroden 5a, 5b sind mit den Außenkontaktierungen 7a, 7b elektrisch verbunden. Dementsprechend ist der Vielschichtkondensator 2 für einen einseitigen Anschluss vorgesehen. Die in Figur 1 gezeigte Schraffur stellt nicht den Verlauf der Elektroden 5a, 5b, 5c dar, sondern dient lediglich dazu, den Vielschichtkondensator 2 besser von weiteren Elementen der Kondensatoranordnung 1 unterscheiden zu können.

Insbesondere sind die Elektroden 5a, 5b und ein piezoelektrisches Material derart in dem keramischen Vielschichtkondensators 2 gestapelt, dass sich in einer Stapelrichtung S jeweils eine Elektrode 5a, die mit der einen Außenkontaktierung 7a verbunden ist, und eine Elektrode 5b, die mit der anderen Außenkontaktierung 7b verbunden ist, abwechseln und dass zwischen je zwei Elektroden 5a, 5b eine Schicht des piezoelektrischen Materials angeordnet ist.

Die Außenkontaktierungen 7a, 7b weisen eine Dicke zwischen 0,1 µm und 1 µm auf. Als "Dicke" wird hier die Ausdehnung der jeweiligen Schicht in eine Richtung bezeichnet, die parallel zur Richtung der Flächennormale der ersten Außenfläche 6 des Vielschichtkondensators 2 ist.

Der Vielschichtkondensator 2 ist mechanisch mit dem Sockel 3 verbunden. Diese Verbindung wird durch eine Schicht 8 hergestellt, die Silber aufweist. Insbesondere kann die Schicht 8 zu 95 Gew.-% oder sogar zu 99 Gew.-% aus reinem Silber bestehen. Die Schicht 8, die den Vielschichtkondensator 2 mit dem Sockel 3 verbindet, wird durch Sintern einer Paste gebildet. Der Vorgang, bei dem der Vielschichtkondensator 2 an dem Sockel 3 befestigt wird, wird auch als Silbersintertechnik bezeichnet. Die Schicht 8 stellt ferner einen elektrischen Kontakt zwischen den Außenkontaktierungen 7a, 7b des Vielschichtkondensators 2 und dem Sockel 3 her. Die Silber aufweisende Schicht 8 weist eine Dicke zwischen 5 µm und 50 µm auf.

Der Sockel 3 weist ein Substrat 9 und Leiterbahnen 10a, 10b auf. Das Substrat 9 besteht aus einem keramischen oder dielektrischen Material, beispielsweise aus Siliziumnitrid, Aluminiumoxid oder Aluminiumnitrid. Das Substrat 9 weist eine quaderförmige Form auf, wobei eine Oberseite 11 des Substrats 9 zum Vielschichtkondensator 2 hingewandt ist und wobei eine Unterseite 12 des Substrats 9 vom Vielschichtkondensator 2 weg weist. Das Substrat 9 weist eine Dicke zwischen 0,2 mm und 1,0 mm auf.

Die Leiterbahnen 10a, 10b verlaufen auf der Oberfläche des Substrats 9 von der Oberseite 11 des Substrats 9 zur Unterseite 12 des Substrats 9 hin. Die Leiterbahnen 10a, 10b bestehen aus einem leitenden Material, beispielsweise aus Kupfer. Die Leiterbahnen 10a, 10b weisen eine Dicke zwischen 0,1 mm und 0,6 mm auf.

Insbesondere weist der Sockel 3 eine erste Leiterbahn 10a und eine zweite Leiterbahn 10b auf. Auf der Oberseite 11 des Substrats 9 befindet sich zwischen den beiden Leiterbahnen 10a, 10b ein mit Luft gefüllter Hohlraum 13. Der Abstand zwischen den beiden Leiterbahnen 10a, 10b ist so groß, dass es nicht zu einem elektrischen Überschlag zwischen der ersten und der zweiten Leiterbahn 10a, 10b kommt. Insbesondere wird der Abstand der beiden Leiterbahnen 10a, 10b voneinander so gewählt, dass an die Kondensatoranordnung 1 gestellte Kriechstreckenanforderungen erfüllt sind. Auch auf der Unterseite 12 des Substrats 9 sind die beiden Leiterbahnen 10a, 10b so weit voneinander entfernt, dass es nicht zu einem elektrischen Überschlag zwischen den beiden Leiterbahnen 10a, 10b kommen kann.

Bei dem Sockel 3 handelt es sich um ein sogenanntes DCB-Bauteil (DCB = Direct Copper Bonding), das manchmal auch als DBC-Bauteil bezeichnet wird (DBC = Direct Bonded Copper). Diese Bauteile sind zur Oberflächenmontage auf einer Leiterplatte geeignet. Es handelt sich dementsprechend bei der Kondensatoranordnung 1 um ein SMD-Bauteil (SMD = Surface Mounted Device). Wird die Kondensatoranordnung 1, aufweisend den Vielschichtkondensator 2 und den Sockel 3, mittels Oberflächenmontage auf einer Leiterplatte befestigt, so können dazu die auf der Unterseite 12 des Substrats 9 angeordneten Leiterbahnen 10a, 10b beispielsweise mittels einer Lötverbindung oder mittels einer durch Sintersilbertechnik gefertigten Verbindungsschicht mit der Leiterplatte verbunden werden.

Der Vielschichtkondensator 2 und der Sockel 3 weisen eine identische Breite B auf. Die Breite B gibt dabei die Ausdehnung des Vielschichtkondensators 2 beziehungsweise des Sockels 3 in eine Raumrichtung an, die senkrecht zu einer Flächennormale der ersten Außenfläche 6 des Vielschichtkondensators 2 ist und die ferner senkrecht zu einer Stapelrichtung S ist, in der die Elektroden 5a, 5b, 5c und die keramischen Schichten 4 in dem Vielschichtkondensator 2 übereinander gestapelt sind. Die Stapelrichtung S zeigt dabei aus der Zeichenebene der Figur 1 heraus.

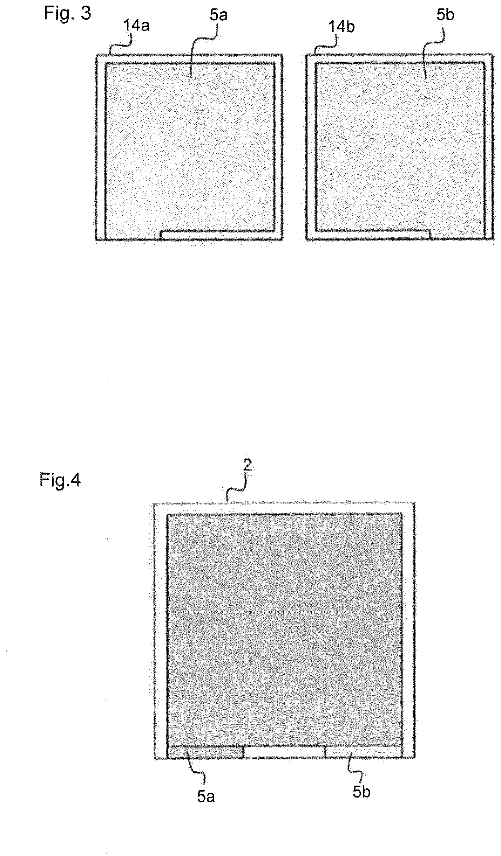

Die Figuren 2 bis 4 zeigen eine Elektrodenkonfiguration des Vielschichtkondensators 2 gemäß einem ersten Ausführungsbeispiel. Die Elektrodenkonfiguration ermöglicht einen einseitigen Anschluss des Vielschichtkondensators 2, wobei die Elektroden 5a, 5b mit den auf der ersten Außenfläche 6 des Vielschichtkondensators 2 angeordneten Außenkontaktierungen 7a, 7b kontaktiert sind. Figur 2 zeigt den Vielschichtkondensator 2 in einer perspektivischen Ansicht. Figur 3 zeigt eine einzelne erste Elektrodenschicht 14a, in der eine erste Elektrode 5a angeordnet ist, und eine einzelne zweite Elektrodenschicht 14b, in der eine zweite Elektrode 5b angeordnet ist. Die ersten und die zweiten Elektrodenschichten 14a, 14b sind in dem Vielschichtkondensator 2 abwechselnd übereinander gestapelte, wobei zwischen zwei Elektrodenschichten 14a, 14b jeweils eine keramische Schicht 4 angeordnet ist. Figur 4 zeigt den Vielschichtkondensator 2 in Draufsicht.

Der Vielschichtkondensator 2 weist gemäß dem ersten Ausführungsbeispiel erste Elektroden 5a und zweite Elektroden 5b auf. Eine erste Elektrode 5a ist in der linken Abbildung der Figur 3 gezeigt. Ein Ende der ersten Elektrode 5a ist dabei zu der ersten Außenfläche 6 des Vielschichtkondensators 2 herausgeführt und mit der ersten Außenkontaktierung 7a verbunden. Mit der zweiten Außenkontaktierung 7b ist die erste Elektrode 5a nicht verbunden.

In der rechten Abbildung der Figur 3 ist eine zweite Elektrode 5b gezeigt. Die zweiten Elektroden 5b sind mit der zweiten Außenkontaktierung 7b verbunden. Ein Ende der zweiten Elektroden 5b liegt an der ersten Außenfläche 6 an. In einer orthogonalen Projektion in Stapelrichtung S überlappen sich die ersten Elektroden 5a und die zweiten Elektroden 5b in weiten Bereichen, nicht jedoch in den Enden, die mit der ersten Außenfläche 6 verbunden sind. Die überlappenden Flächen der ersten und der zweiten Elektroden 5a, 5b sind insbesondere in der in Figur 4 gezeigten Draufsicht deutlich zu erkennen.

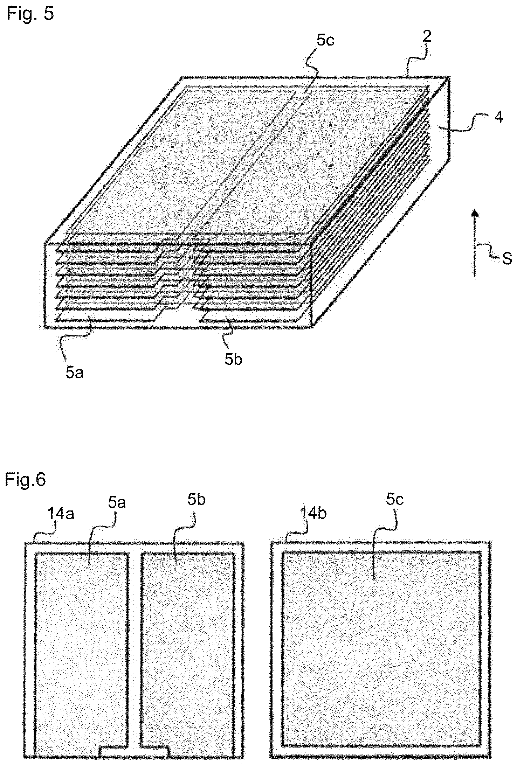

Die Figuren 5 bis 7 zeigen ein zweites Ausführungsbeispiel für eine Elektrodenkonfiguration des Vielschichtkondensators 2. Figur 5 zeigt die Elektrodenkonfiguration in dem Vielschichtkondensator 2 in perspektivischer Ansicht. Figur 6 zeigt eine einzelne erste Elektrodenschicht 14a, in der eine erste Elektrode 5a und eine zweite Elektrode 5b angeordnet sind, und eine einzelne zweite Elektrodenschicht 14b, in der eine dritte Elektrode 5c angeordnet ist. Die ersten und die zweiten Elektrodenschichten 14a, 14b sind in dem Vielschichtkondensator 2 abwechselnd übereinander gestapelte, wobei zwischen zwei Elektrodenschichten 14a, 14b jeweils eine keramische Schicht 4 angeordnet ist. Figur 4 zeigt den Vielschichtkondensator 2 in Draufsicht.

Gemäß dem zweiten Ausführungsbeispiel weist der Vielschichtkondensator somit erste Elektroden 5a, zweite Elektroden 5b und dritte Elektroden 5c auf. In der ersten Elektrodenschicht 14a sind die ersten Elektroden 5a und die zweiten Elektroden 5b angeordnet. Dabei ist ein Ende der ersten Elektroden 5a jeweils mit der ersten Außenkontaktierung 7a auf der ersten Außenfläche 6 des Vielschichtkondensators 2 verbunden. Ein Ende der zweiten Elektroden 5b ist mit der zweiten Außenkontaktierung 7b auf der ersten Außenfläche 6 verbunden. Die ersten Elektroden 5a und die zweiten Elektroden 5b berühren einander nicht.

Ferner weist der Vielschichtkondensator 2 die dritten Elektroden 5c auf, die in den zweiten Elektrodenschichten 14b angeordnet sind. Die dritten Elektroden 5c sind mit keiner der Außenkontaktierungen 7a, 7b verbunden. Die dritten Elektroden 5c überlappen sowohl mit den ersten Elektroden 5a als auch mit den zweiten Elektroden 5b in einer orthogonalen Projektion in Stapelrichtung S. Dementsprechend werden in dem Vielschichtkondensator 2 zwei interne Kondensatoren gebildet, die serielle verbunden sind. Dabei wird ein erster interner Kondensator von den ersten und den dritten Elektroden 5a, 5c gebildet und ein zweiter interner Kondensator wird von den zweiten und den dritten Elektroden 5b, 5c gebildet. Es handelt sich um einen MLSC-Kondensator (MLSC = Multi Layer Serial Capacitor).

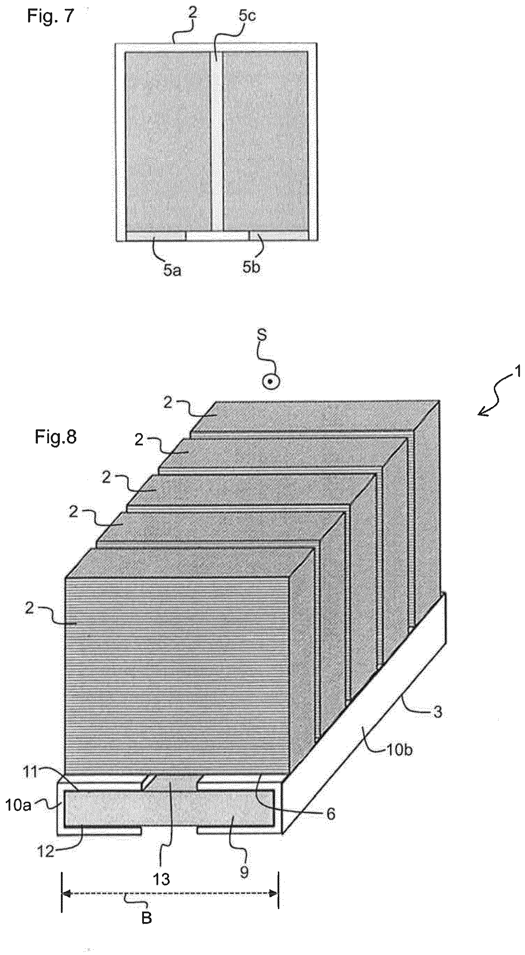

Figur 8 zeigt ein weiteres Ausführungsbeispiel für die Kondensatoranordnung 1.

Gemäß dem weiteren Ausführungsbeispiel weist die Kondensatoranordnung 1 mehrere Vielschichtkondensatoren 2 auf. Die Vielschichtkondensatoren 2 können dabei die strukturellen und funktionellen Merkmale aufweisen, die im Zusammenhang mit den Figuren 1 bis 7 für den einen Vielschichtkondensator 2 offenbart wurden. Die Vielschichtkondensatoren 2 sind jeweils mit einer ersten Außenfläche 6 mit den Leiterbahnen des Sockels 3 mechanisch und elektrisch verbunden. Die Vielschichtkondensatoren 2 sind zueinander parallel verschaltet.

Die Vielschichtkondensatoren 2 sind hintereinander in einer Richtung angeordnet, die der Stapelrichtung S der Vielschichtkondensatoren 2 entspricht. Die Vielschichtkondensatoren 2 und der Sockel 3 weisen eine identische Breite B auf.

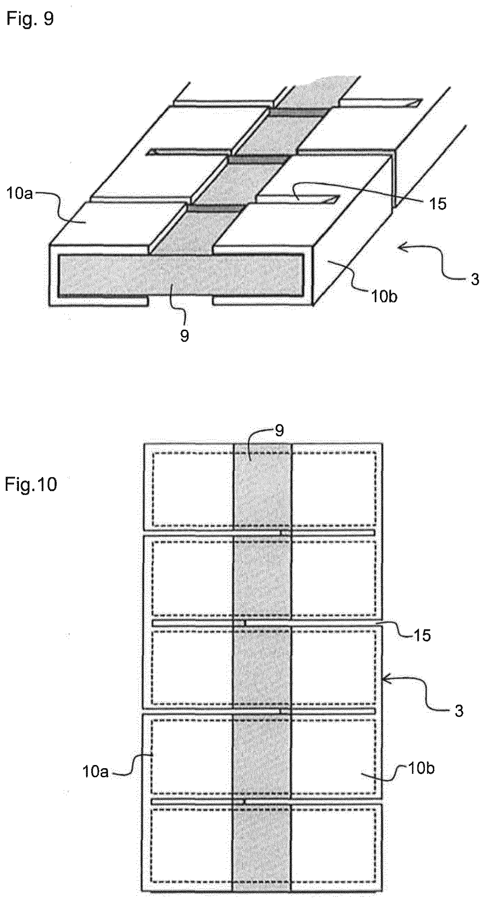

Figur 9 zeigt den Sockel 3 in einer perspektivischen Ansicht. Der Sockel 3 weist Schlitze 15 auf. Die Schlitze 15 können zur mechanischen Entlastung des Sockels 3 beitragen. Beispielsweise können die Schlitze 15 mechanische Spannungen abbauen, die sich durch Unterschiede zwischen den thermischen Ausdehnungskoeffizienten der Vielschichtkondensatoren 2 und dem thermischen Ausdehnungskoeffizient des Sockels 3 ergeben können.

Weist die Kondensatoranordnung 1 mehrere Vielschichtkondensatoren 2 auf, die auf dem Sockel 3 angeordnet sind, so können die Schlitze 15 jeweils zwischen zwei Vielschichtkondensatoren 2 angeordnet sein. Eine signifikante Reduktion der thermischen Leitfähigkeit der Verbindung des Sockels 3 mit einer Leiterplatte ist bei einer Oberflächenmontage der Kondensatoranordnung 1 durch die Schlitze 15 nicht zu erwarten, da die Fläche, mit der der Sockel 3 auf einer Leiterplatte angebunden ist, durch die Schlitze 15 nicht wesentlich verkleinert wird.

Ferner ist es möglich eine Vielzahl von Kondensatoranordnungen 1 gemeinsam zu fertigen. Dabei können eine Vielzahl von Vielschichtkondensatoren 2 auf einem einzigen Sockel 3 angeordnet werden, der Schlitze 15 aufweist. Der Sockel 3 kann dann entlang der Schlitze 15 in mehrere Bauteile vereinzelt werden. Die Schlitze 15 können somit während eines Herstellungsverfahrens als Sollbruchstellen verwendet werden.

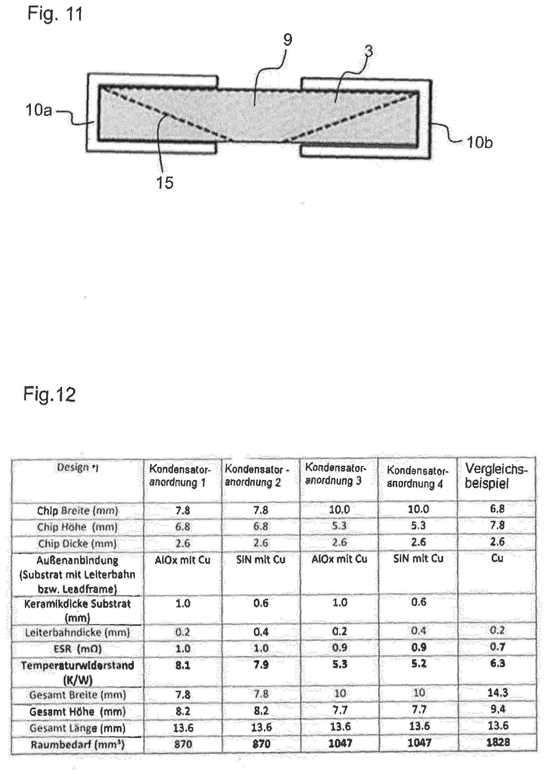

Figur 10 zeigt den in Figur 9 gezeigten Sockel 3 in einer Draufsicht. Figur 11 zeigt den Sockel 3 in einer Ansicht von vorn.

Figur 12 zeigt eine tabellarische Übersicht über Simulationsergebnisse, die verschiedene Eigenschaften der erfindungsgemäßen Kondensatoranordnung 1 mit einer Vergleichskondensatoranordnung vergleicht. Bei der Vergleichskondensatoranordnung weist ein Vielschichtkondensator eine gesinterten Silberschicht, die mit einer Außenelektrode eines Vielschichtkondensators verbunden ist, und einen Kupferrahmen auf, der an der gesinterten Silberschicht befestigt ist. Der Kupferrahmen ist rechtwinklig geformt und ermöglicht die Kontaktierung der Vergleichskondensatoranordnung an einer Leiterplatte.

In der zweiten bis fünften Spalte wird jeweils eine erfindungsgemäße Kondensatoranordnung 1 betrachtet. In der sechsten Spalte wird die oben beschriebene Vergleichskondensatoranordnung betrachtet. Jede der Kondensatoranordnungen weist einen einzigen Vielschichtkondensator 2 auf, wobei die Anzahl und die Dicke der Elektroden 5s, 5b, 5c in den Vielschichtkondensatoren 2 bei allen Kondensatoranordnungen 1 identisch sind.

Anhand den in Figur 12 gezeigten Simulationsergebnissen ist zu erkennen, dass der Temperaturwiderstand bzw. die thermische Leitfähigkeit, die sich als Kehrwert des Temperaturwiderstand ergibt, bei den erfindungsgemäßen Kondensatoranordnung 1 ähnlich und zum Teil sogar besser ist als bei der Vergleichskondensatoranordnung, die massive metallische Leiter aufweist. Die erfindungsgemäßen Kondensatoranordnungen 1 zeichnen sich gegenüber der Vergleichskondensatoranordnung durch einen kleineren Bauraumbedarf und eine größere Anbindungsfläche an eine Leiterplatte aus. Insbesondere der untersten Zeile der Tabelle ist zu entnehmen, dass bei den erfindungsgemäßen Kondensatoranordnungen 1 der Bauraumbedarf erheblich verringert ist. Dieses ist insbesondere darauf zurückzuführen, dass die Verwendung des Sockels 3, auf dem der Vielschichtkondensator 2 befestigt ist, es ermöglicht, eine Kondensatoranordnung 1 zu konstruieren, deren Breite B identisch zu der Breite des Vielschichtkondensators 2 ist. Bei der Vergleichskondensatoranordnung muss dagegen die Breite der Anordnung deutlich größer sein als die Breite des Vielschichtkondensators, da durch den Kupferrahmen die Breite vergrößert wird.

### Bezugszeichenliste

- 1: Kondensatoranordnung
- 2: Vielschichtkondensator
- 3: Sockel
- 4: keramische Schicht
- 5a: Elektrode
- 5b: Elektrode
- 5c: Elektrode
- 6: erste Außenfläche
- 7a: Außenkontaktierung
- 7b: Außenkontaktierung
- 8: Schicht
- 9: Substrat
- 10a: Leiterbahn
- 10b: Leiterbahn
- 11: Oberseite des Substrats
- 12: Unterseite des Substrats
- 13: Hohlraum
- 14a: erste Elektrodenschicht
- 14b: zweite Elektrodenschicht
- 15: Schlitz

- B: Breite
- S: Stapelrichtung

## Patentansprüche

1. Kondensatoranordnung (1) aufweisend
- zumindest einen keramischen Vielschichtkondensator (2), der keramische Schichten (4) und dazwischen angeordnete erste und zweite Elektroden (5a, 5b) aufweist, und
- einen Sockel (3), der ein Substrat (9) und Leiterbahnen (10a, 10b) aufweist, wobei die Leiterbahnen (10a, 10b) von einer zum Vielschichtkondensator (2) hinweisenden Oberseite (11) des Substrats (9) zu einer vom Vielschichtkondensator (2) wegweisenden Unterseite (12) des Substrats (9) führen,
wobei der Vielschichtkondensator (2) mechanisch auf dem Sockel (3) befestigt ist und wobei die ersten Elektroden (5a) und die zweiten Elektroden (5b) mit den Leiterbahnen (10a, 10b) elektrisch kontaktiert sind, wobei der Vielschichtkondensator (2) Außenkontaktierungen (7a, 7b) aufweist,
wobei der Vielschichtkondensator (2) für einen einseitigen Anschluss ausgelegt ist, bei dem sämtliche Außenkontaktierungen (7a, 7b) auf einer zum Sockel (3) weisend Außenfläche (6) angeordnet sind,
wobei ein zweiter keramischer Vielschichtkondensator (2), der keramische Schichten (4) und dazwischen angeordnete Elektroden (5a, 5b, 5c) aufweist, auf dem Sockel (3) angeordnet ist, und
wobei die Elektroden (5a, 5b) des zweiten Vielschichtkondensators (2) mit den Leiterbahnen (10a, 10b) elektrisch kontaktiert sind,
wobei der Sockel (3) zumindest einen Schlitz (15) aufweist, der zwischen dem keramischen Vielschichtkondensator (2) und dem zweiten keramischen Vielschichtkondensator (2) verläuft.

2. Kondensatoranordnung (1) gemäß dem vorherigen Anspruch, wobei die ersten und die zweiten Elektroden (5a, 5b) des Vielschichtkondensators (2) jeweils an der zum Sockel weisenden Außenfläche (6) des Vielschichtkondensators anliegen.

3. Kondensatoranordnung (1) gemäß einem der vorherigen Ansprüche,
wobei der Vielschichtkondensator (2) eine erste Außenkontaktierung (7a) und eine zweite Außenkontaktierung (7b) aufweist, die auf ein und derselben Außenfläche (6) des Vielschichtkondensators (2) angeordnet sind,
wobei die ersten Elektroden (5a) über die erste Außenkontaktierung (7a) mit einer der Leiterbahnen (10a) verbunden sind, und
wobei die zweiten Elektroden (5b) über die zweite , Außenkontaktierung (7b) mit einer der Leiterbahnen (10b) verbunden sind.

4. Kondensatoranordnung (1) gemäß einem der vorherigen Ansprüche,
wobei der Vielschichtkondensator (2) mit zumindest der Hälfte der ersten Außenfläche (6) unmittelbar auf dem Sockel (3) aufliegt.

5. Kondensatoranordnung (1) gemäß einem der vorherigen Ansprüche,
wobei der keramische Vielschichtkondensator (2) mit dem Sockel (3) durch eine Silber aufweisende Schicht (8) verbunden ist.

6. Kondensatoranordnung (1) gemäß einem der vorherigen Ansprüche,
wobei der keramische Vielschichtkondensator (2) mit dem Sockel (3) durch eine Schicht (8) verbunden ist, die durch das Auftragen einer Paste und anschließendes Sintern gebildet wird.

7. Kondensatoranordnung (1) gemäß einem der vorherigen Ansprüche,
wobei der keramischen Vielschichtkondensator (2) und der zweite keramische Vielschichtkondensator (2) zueinander parallel geschaltet sind.

8. Kondensatoranordnung (1) gemäß einem der vorherigen Ansprüche,
wobei die Kondensatoranordnung (1) ein SMD-Bauteil ist.

9. Kondensatoranordnung (1) gemäß einem der vorherigen Ansprüche,
wobei das Material und die Dicke des Substrats (9) sowie das Material und die Dicke der Leiterbahnen (10a, 10b) so gewählt wird, dass der Sockel (3) einen thermischen Ausdehnungskoeffizienten aufweist, der an den thermischen Ausdehnungskoeffizienten des Vielschichtkondensators (2) angepasst ist.

10. Kondensatoranordnung (1) gemäß einem der vorherigen Ansprüche,
wobei der Sockel (3) und der Vielschichtkondensator (2) die gleiche Breite (B) aufweisen.

11. Kondensatoranordnung (1) gemäß einem der vorherigen Ansprüche,
wobei das Substrat (9) Siliziumnitrid, Aluminiumoxid oder Aluminiumnitrid aufweist.

12. Kondensatoranordnung (1) gemäß einem der vorherigen Ansprüche,
wobei die Leiterbahnen (10a, 10b) aus Kupfer bestehen.

13. Kondensatoranordnung (1) gemäß einem der vorherigen Ansprüche,
wobei die Leiterbahnen (10a, 10b) eine Dicke zwischen 0,05 mm und 1,0 mm aufweist.

## Claims

1. Capacitor assembly (1) having
- at least one ceramic multilayer capacitor (2), which has ceramic layers (4) and first and second electrodes (5a, 5b) arranged therebetween, and
- a base (3), which has a substrate (9) and conductor tracks (10a, 10b), wherein the conductor tracks (10a, 10b) lead from a top (11) of the substrate (9) facing towards the multilayer capacitor (2) to a bottom (12) of the substrate (9) facing away from the multilayer capacitor (2),
wherein the multilayer capacitor (2) is fastened mechanically to the base (3) and wherein the first electrodes (5a) and the second electrodes (5b) are electrically contacted with the conductor tracks (10a, 10b), wherein the multilayer capacitor (2) has external contacts (7a, 7b),
wherein the multilayer capacitor (2) is designed for unilateral connection, in which all the external contacts (7a, 7b) are arranged on an outer face (6) facing the base (3),
wherein a second ceramic multilayer capacitor (2), which has ceramic layers (4) and electrodes (5a, 5b, 5c) arranged therebetween, is arranged on the base (3), and wherein the electrodes (5a, 5b) of the second multilayer capacitor (2) are electrically contacted with the conductor tracks (10a, 10b),
wherein the base (3) has at least one slot (15), which extends between the ceramic multilayer capacitor (2) and the second ceramic multilayer capacitor (2).

2. Capacitor assembly (1) according to the preceding claim, wherein the first and second electrodes (5a, 5b) of the multilayer capacitor (2) each rest against the outer face (6), facing the base, of the multilayer capacitor.

3. Capacitor assembly (1) according to one of the preceding claims,
wherein the multilayer capacitor (2) has a first external contact (7a) and a second external contact (7b), which are arranged on one and the same outer face (6) of the multilayer capacitor (2),
wherein the first electrodes (5a) are connected via the first external contact (7a) to one of the conductor tracks (10a), and
wherein the second electrodes (5b) are connected via the second external contact (7b) to one of the conductor tracks (10b).

4. Capacitor assembly (1) according to one of the preceding claims,
wherein the multilayer capacitor (2) rests with at least half of the first outer face (6) directly on the base (3) .

5. Capacitor assembly (1) according to one of the preceding claims,
wherein the ceramic multilayer capacitor (2) is connected to the base (3) by a layer (8) comprising silver.

6. Capacitor assembly (1) according to one of the preceding claims,
wherein the ceramic multilayer capacitor (2) is connected to the base (3) by a layer (8) which is formed by applying a paste and then sintering.

7. Capacitor assembly (1) according to one of the preceding claims,
wherein the ceramic multilayer capacitor (2) and the second ceramic multilayer capacitor (2) are connected together in parallel.

8. Capacitor assembly (1) according to one of the preceding claims, wherein the capacitor assembly (1) is an SMD component.

9. Capacitor assembly (1) according to one of the preceding claims,
wherein the material and thickness of the substrate (9) and the material and thickness of the conductor tracks (10a, 10b) are selected such that the base (3) has a coefficient of thermal expansion which is adapted to the coefficient of thermal expansion of the multilayer capacitor (2).

10. Capacitor assembly (1) according to one of the preceding claims,
wherein the base (3) and the multilayer capacitor (2) have the same width (B).

11. Capacitor assembly (1) according to one of the preceding claims,
wherein the substrate (9) comprises silicon nitride, aluminum oxide or aluminum nitride.

12. Capacitor assembly (1) according to one of the preceding claims, wherein the conductor tracks (10a, 10b) consist of copper.

13. Capacitor assembly (1) according to one of the preceding claims,
wherein the conductor tracks (10a, 10b) have a thickness of between 0.05 mm and 1.0 mm.

## Revendications

1. Agencement de condensateur (1), présentant
- au moins un condensateur multicouche céramique (2), qui présente des couches céramiques (4) et des premières et des deuxièmes électrodes (5a, 5b) disposées entre celles-ci et
- un socle (3), qui présente un substrat (9) et des bandes conductrices (10a, 10b), les bandes conductrices (10a, 10b) allant d'une face supérieure (11) du substrat (9) orientée vers le condensateur multicouche (2) vers une face inférieure (12) du substrat (9) à l'opposé du condensateur multicouche (2),
le condensateur multicouche (2) étant fixé mécaniquement sur le socle (3) et les premières électrodes (5a) et les deuxièmes électrodes (5b) étant en contact électrique avec les bandes conductrices (10a, 10b),
le condensateur multicouche (2) présentant des contacts externes (7a, 7b),
le condensateur multicouche (2) étant conçu pour un raccordement d'un seul côté, dans lequel l'ensemble des contacts externes (7a, 7b) sont agencés sur une surface externe (6) orientée vers le socle (3),
un deuxième condensateur multicouche céramique (2), qui présente des couches céramiques (4) et des électrodes (5a, 5b, 5c) disposées entre celles-ci étant disposé sur le socle (3) et
les électrodes (5a, 5b) du deuxième condensateur multicouche (2) étant en contact électrique avec les bandes conductrices (10a, 10b),
le socle (3) présentant au moins une fente (15), qui s'étend entre le condensateur multicouche céramique (2) et le deuxième condensateur multicouche céramique (2).

2. Agencement de condensateur (1) selon la revendication précédente,
les premières et les deuxièmes électrodes (5a, 5b) du condensateur multicouche (2) s'appliquant à chaque fois sur la surface externe (6) orientée vers le socle du condensateur multicouche.

3. Agencement de condensateur (1) selon l'une quelconque des revendications précédentes,
le condensateur multicouche (2) présentant un premier contact externe (7a) et un deuxième contact externe (7b), qui sont agencés sur une seule et même surface externe (6) du condensateur multicouche (2),
les premières électrodes (5a) étant reliées via le premier contact externe (7a) à l'une des bandes conductrices (10a) et les deuxièmes électrodes (5b) étant reliées via le deuxième contact externe (7b) à l'une des bandes conductrices (10b).

4. Agencement de condensateur (1) selon l'une quelconque des revendications précédentes,
le condensateur multicouche (2) se plaçant avec au moins la moitié de la première surface externe (6) directement sur le socle (3).

5. Agencement de condensateur (1) selon l'une quelconque des revendications précédentes,
le condensateur multicouche céramique (2) étant relié au socle (3) par une couche (8) présentant de l'argent.

6. Agencement de condensateur (1) selon l'une quelconque des revendications précédentes,
le condensateur multicouche céramique (2) étant relié au socle (3) par une couche (8) qui est formée par l'application d'une pâte et par frittage consécutif.

7. Agencement de condensateur (1) selon l'une quelconque des revendications précédentes,
le condensateur multicouche céramique (2) et le deuxième condensateur multicouche céramique (2) étant commutés en parallèle l'un par rapport à l'autre.

8. Agencement de condensateur (1) selon l'une quelconque des revendications précédentes,
l'agencement de condensateur (1) étant une pièce SMD (composant monté en surface).

9. Agencement de condensateur (1) selon l'une quelconque des revendications précédentes,
le matériau et l'épaisseur du substrat (9) ainsi que le matériau et l'épaisseur des bandes conductrices (10a, 10b) étant choisis de manière telle que le socle (3) présente un coefficient de dilatation thermique qui est adapté au coefficient de dilatation thermique du condensateur multicouche (2).

10. Agencement de condensateur (1) selon l'une quelconque des revendications précédentes,
le socle (3) et le condensateur multicouche (2) présentant la même largeur (B).

11. Agencement de condensateur (1) selon l'une quelconque des revendications précédentes,
le substrat (9) présentant du nitrure de silicium, de l'oxyde d'aluminium ou du nitrure d'aluminium.

12. Agencement de condensateur (1) selon l'une quelconque des revendications précédentes,
les bandes conductrices (10a, 10b) étant constituées de cuivre.

13. Agencement de condensateur (1) selon l'une quelconque des revendications précédentes,
les bandes conductrices (10a, 10b) présentant une épaisseur entre 0,05 mm et 1,0 mm.
